# EUROPÄISCHE PATENTANMELDUNG

(11) **EP 0 612 109 A2**
(43) Veröffentlichungstag der Anmeldung: **24.08.1994**
(21) Anmeldenummer: 94101103.3
(22) Anmeldetag: 26.01.1994
(51) Int. Cl.: H01L 29/06, H01L 29/90

(54) **Monolithisch integriertes Bauelement und Verfahren zu seiner Herstellung**

(30) Priorität: 16.02.1993 DE 4304643; 04.06.1993 DE 4318617
(71) Anmelder: ROBERT BOSCH GMBH, 70442 Stuttgart (DE)
(72) Erfinder: Marolt, Vinko, D-72768 Reutlingen (DE)
(74) Vertreter: Friedmann, Jürgen, Dr.-Ing.

(57) **Zusammenfassung**

Es wird ein monolithisch integriertes Bauelement und ein Verfahren zu seiner Herstellung vorgeschlagen, das eine in eine Halbleiterschicht eingebettete P⁺-Struktur aufweist, die teilweise von einer N⁺-Struktur überlappt wird und mit einer Oxidschicht überzogen ist, und bei dem eine Langzeitstabilisierung der Durchbruchspannung bei Zenerdioden mit Durchbruch an der Oberfläche gewährleistet ist.

Dazu ist vorgesehen, daß die Oxidschicht (20) in einem Bereich (35) abgetragen ist und dort eine Oxidschicht (36) angeordnet ist, die Fenster (22, 24) aufweist, die den Bereich der P⁺-Struktur (14) und den Bereich der N⁺-Struktur (16) definieren und im Überlappungsbereich (32) oberhalb des PN-Überganges (18) ein Polysiliciumsteg (30) angeordnet ist.

## Beschreibung

Die Erfindung betrifft ein monolithisch integriertes Bauelement und ein Verfahren zu seiner Herstellung nach den Oberbegriffen der Ansprüche 1 und 7.

Es ist bekannt, zur Stabilisierung der Durchbruchspannung bei Zenerdioden den Grenzschichtübergang zu verpacken.

So ist in der DE-OS 28 27 564 ein monolithisch integriertes Referenzelement aus einer im Sperrspannungsdurchbruch betriebenen Basis-Emitter-Diode beschrieben. Dort wird der Emitter ringförmig in die Basis hinein und um den Basiskontakt herum gelegt, wobei die Kontaktmetallisierung der Basis soweit über die isolierende Siliciumdioxidschicht gezogen wird, daß sie den an die Halbleiteroberfläche tretenden Rand des zwischen Emitter und Basis angeordneten PN-Übergangs überdecken. Es ist jedoch nachteilig, daß mit dieser Anordnung die Zenerdiode vor störenden Aufladungseffekten an der Oberfläche des PN-Überganges nur unzulänglich geschützt werden kann und eine Verbesserung der Stabilität der Durchbruchspannung nur begrenzt möglich ist.

Es ist Aufgabe der Erfindung, ein monolithisch integriertes Bauelement der gattungsgemäßen Art zu schaffen, das eine Langzeitstabilisierung der Durchbruchspannung bei Zenerdioden mit Durchbruch an der Oberfläche gewährleistet und ein Verfahren zur Herstellung der Bauelemente anzugeben.

Erfindungsgemäß wird die Aufgabe durch die kennzeichnenden Merkmale der Hauptansprüche 1 und 7 gelöst.

Es hat sich als sehr vorteilhaft erwiesen, daß durch die Bildung eines Polysiliciumsteges, der gleichzeitig als Maske für die Implantation der N⁺-Struktur dient, eine einfache Abdeckelung des PN-Überganges durch eine Polysiliciumschicht möglich ist.

Der Polysiliciumsteg dient gleichzeitig als Feldplatte und kann bei Anschluß eines geeigneten Potentials an den Polysiliciumsteg die Stabilität der Durchbruchspannung aufgrund der Feldplattenwirkung verbessern.

Darüber hinaus schützt der Polysiliciumsteg die Zenerdiode vor störenden Aufladungseffekten im Oxid an der Oberfläche des PN-Überganges.

Weitere Vorteile ergeben sich aus den in den Unteransprüchen angeführten Merkmalen.

Die Erfindung soll nachfolgend in einem Ausführungsbeispiel anhand der zugehörigen Zeichnungen näher erläutert werden. Es zeigen:
- Figur 1: den Schnitt durch ein erfindungsgemäßes monolithisch integriertes Bauelement und
- Figur 2: das Bauelement in Draufsicht.

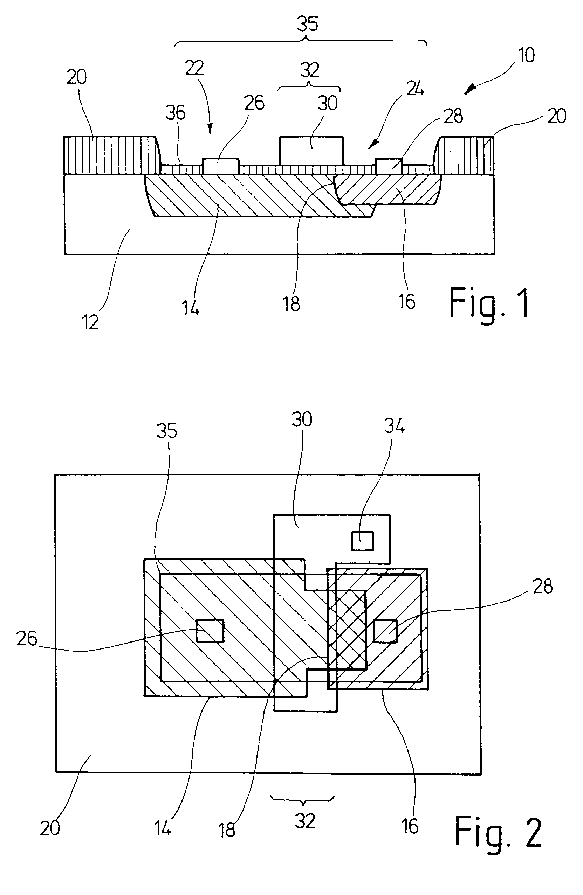

In Figur 1 ist im Schnitt ein allgemein mit 10 bezeichnetes monolitisch integriertes Bauelement dargestellt. Das Bauelement 10 weist eine in eine Halbleiterschicht 12 eingebettete P⁺-Struktur 14 auf. Die P⁺-Struktur 14 wird teilweise von einer N⁺-Struktur 16 überlappt, so daß sich ein PN-Übergang 18 ergibt. Auf diese Anordnung ist eine isolierende Oxidschicht 20 aufgebracht, die in einem Bereich 35 auf ein Minimum abgetragen ist und dort eine Oxidschicht 36 bildet.

Auf der Oxidschicht 36 ist ein Polysiliciumsteg 30 aufgebracht, der den Überlappungsbereich 32 der P⁺-Struktur 14 und der N⁺-Struktur 16 oberhalb der Oxidschicht 36 abdeckt. Der Polysiliciumsteg 30 besitzt eine Anschlußstelle 34.

Durch die Oxidschicht 36 führen Anschlüsse 26 und 28 zu der P⁺-Struktur 14 und der N⁺-Struktur 16 hindurch.

Die P⁺-Struktur 14 ist so dimensioniert, daß sie ganzflächig unter dem Polysiliciumsteg 30 zu liegen kommt.

In der in Figur 2 dargestellten Draufsicht wird deutlich, daß der Polysiliciumsteg 30 den Überlappungsbereich 32 mit dem PN-Übergang 18 vollständig übergreift. Aus Gründen der Übersichtlichkeit ist in Figur 2 die isolierende Oxidschicht 36 nicht dargestellt.

Während des Betriebes treten hohe Feldstärken am PN-Übergang 18 auf, die gemeinsam mit im Durchbruch betriebenem PN-Übergang 18 zu Aufladungseffekten, insbesondere an der Oberfläche innerhalb des Überlappungsbereiches 32 in der isolierenden Oxidschicht 36 führen.

Indem an der Anschlußstelle 34 des Polysiliciumsteges 30 ein geeignetes Potential, beispielsweise die Anode der Zenerdiode, angelegt wird, kann aufgrund der Feldplattenwirkung des Polysiliciumsteges 30 die Langzeitstabilität der Durchbruchspannung entscheidend verbessert werden.

Der Polysiliciumsteg 30 erfüllt gleichzeitig die Funktion einer schützenden Abdeckelung des monolithisch integrierten Bauelements 10 und schützt so die isolierende Oxidschicht im Bereich den PN-Überganges 18 vor unerwünschten Aufladungseffekten.

Indem bei der Herstellung des Bauelementes 10 die Implantation der N⁺-Struktur 16 nach der fensterbildenden Polysiliciumabscheidung erfolgt, dient der angeordnete Polysiliciumsteg 30 gleichzeitig als Maske für die Implantation der N⁺-Struktur 16. Die Implantation erfolgt in dem durch das Fenster 24 definierten Bereich und bildet den PN-Übergang 18.

Aufgrund lateraler Diffusionsvorgänge verschiebt sich der PN-Übergang 18 unter den Polysiliciumsteg 30 und ist somit in der oben beschriebenen Weise beeinflußbar und gleichzeitig geschützt.

## Patentansprüche

1. Monolithisch integriertes Bauelement mit einer in einer Halbleiterschicht eingebetteten P⁺-Struktur, die teilweise von einer N⁺-Struktur überlappt wird, und mit einer Oxidschicht überzogen ist, **dadurch gekennzeichnet,** daß die Oxidschicht (20) in einem Bereich (35) abgetragen ist und dort eine Oxidschicht (36) angeordnet ist, die Fenster (22, 24) aufweist, die den Bereich der P⁺-Struktur (14) und den Bereich der N⁺-Struktur (16) definieren und im Überlappungsbereich (32) oberhalb des PN-Überganges (18) ein Polysiliciumsteg (30) angeordnet ist.

2. Monolithisch integriertes Bauelement nach Anspruch 1, **dadurch gekennzeichnet,** daß die P⁺-Struktur (14) ganzflächig unterhalb des Polysiliciumsteges (30) angeordnet ist.

3. Monolithisch integriertes Bauelement nach den vorhergehenden Ansprüchen, **dadurch gekennzeichnet,** daß der PN-Übergang (18) sich vollständig unterhalb des Polysiliciumsteges (30) befindet.

4. Monolithisch integriertes Bauelement nach den vorhergehenden Ansprüchen, **dadurch gekennzeichnet,** daß der Polysiliciumsteg (30) über eine Anschlußstelle (34) an einem Potential angeschlossen ist.

5. Monolithisch integriertes Bauelement nach den vorhergehenden Ansprüchen, **dadurch gekennzeichnet,** daß zwischen dem Polysiliciumsteg (30) und der P⁺-Struktur (14) und der N⁺-Struktur (16) die isolierende Oxidschicht (36) angeordnet ist.

6. Verfahren zur Herstellung eines monolithisch integrierten Bauelementes mit einer in einer Halbleiterschicht eingebetteten P⁺-Struktur, die von einer N⁺-Struktur überlappt wird, und mit einer Oxidschicht überzogen ist, **dadurch gekennzeichnet,** daß die Oxidschicht (20) in einem Bereich (35) abgetragen, vorzugsweise freigeätzt, wird, dort eine Oxidschicht (36) aufgebracht wird, in dem Bereich (35) ein Polysiliciumsteg (30) aufgebracht wird und die Diffusion der P⁺-Struktur (14) vor der Polysiliciumabscheidung und die Implantation der N⁺-Struktur (16) nach der Polysiliciumabscheidung erfolgt.

7. Verfahren nach Anspruch 7, **dadurch gekennzeichnet,** daß bei der Implantation der N⁺-Struktur (16) der PN-Übergang (18) zunächst an die Kante des Polysiliciumsteges (30) gelegt wird und dann infolge lateraler Diffusionsvorgänge unter den Polysiliciumsteg (30) geschoben wird.
